# FASCICULE DE BREVET EUROPEEN

(11) **EP 4 358 157 B1**
(45) Date de publication et mention de la délivrance du brevet: **21.05.2025**
(21) Numéro de dépôt: 23204370.3
(22) Date de dépôt: 18.10.2023
(51) Int. Cl.: H01L 31/05, H01L 31/18

(54) **AUGMENTATION DE LA DENSIFICATION DE MODULES SOLAIRES PAR INTERCONNEXION SUPERPOSÉE MAXIMISÉE**
ERHÖHUNG DER VERDICHTUNG VON SOLARMODULEN DURCH MAXIMIERTE ÜBERLAGERTE VERBINDUNG
INCREASING DENSIFICATION OF SOLAR MODULES BY MAXIMIZED STACKED INTERCONNECTION

(30) Priorité: 20.10.2022 FR 2210864
(43) Date de publication de la demande: 24.04.2024
(73) Titulaire: Commissariat à l'Energie Atomique et aux Energies Alternatives, 75015 Paris (FR)
(72) Inventeur: SOULAS, Romain, 38054 GRENOBLE CEDEX 09 (FR); CHAMBION, Bertrand, 38054 GRENOBLE CEDEX 09 (FR)
(74) Mandataire: Brevalex

(56) Documents cités:
- EP-A1- 3 089 356
- EP-A1- 3 297 037
- WO-A1-2017/021289

## Description

### DOMAINE TECHNIQUE ET ART ANTERIEUR

La présente demande concerne le domaine de la réalisation des modules photovoltaïques et prévoit un assemblage amélioré de plusieurs chaines de cellules solaires ou photovoltaïques interconnectées et notamment des cellules photovoltaïques à base de silicium cristallin.

Un module solaire conventionnel est typiquement formé de plusieurs chaines de cellules juxtaposées communément appelés « strings » selon la terminologie anglo-saxonne.

Une chaine ou « string » de cellules comporte une succession de plusieurs cellules connectées électriquement entre elles et généralement alignées dans une première direction donnée. La connexion entre cellules d'une même chaine peut être réalisée par l'intermédiaire de rubans ou de fils conducteurs qui s'étendent dans la première direction et viennent successivement en contact avec au moins une face supérieure ou inférieure de chaque cellule.

Un module comporte généralement, dans une direction orthogonale à la première direction, plusieurs de chaines de cellules parallèles entre elles.

Pour améliorer la puissance surfacique d'un module photovoltaïque, on peut chercher à augmenter le rendement des cellules et/ou chercher à densifier la surface active des modules.

Il est connu de réaliser une densification des modules en diminuant les espaces inter-cellules au sein d'une même chaine de cellules, voire même en faisant se chevaucher entre elles les cellules d'une même chaine.

Le document US2021202784 décrit par exemple une manière particulière d'assembler les cellules d'une chaine de cellules dans laquelle les cellules se chevauchent entre elles selon un agencement de type en bardeau et communément appelé « shingle » ou, hormis les cellules d'extrémité d'une chaine, chaque cellule chevauche une cellule voisine précédente et est chevauchée par une cellule voisine suivante de la succession de cellules formant la chaine. Une structure de type appelé « pavage » (« paving » selon la terminologie anglo-saxonne), reprend un agencement similaire mais avec des rubans ou de fils conducteurs pour réaliser la connexion entre les cellules.

Un autre type d'agencement prévoit, hormis pour les cellules d'extrémité d'une chaine, que chaque cellule est soit chevauchée par ses cellules voisines précédente et suivante, soit chevauche ses cellules voisines précédente et suivante de la succession de cellules. Le document EP 3297037A1 décrit un dispositif comprenant un assemblage de plusieurs chaines de cellules photovoltaïques en connexion série entre les chaines .

Il se pose le problème de trouver un nouveau moyen d'améliorer la puissance surfacique d'un module photovoltaïque.

### EXPOSÉ DE L'INVENTION

La présente invention concerne notamment un dispositif photovoltaïque comprenant un assemblage de plusieurs chaines de cellules, cet assemblage comportant au moins une première chaine chevauchée latéralement par une deuxième chaine de cellules, la première chaine et la deuxième chaine étant isolées électriquement l'une de l'autre par l'intermédiaire d'une région isolante intercalée entre une portion périphérique de la première chaine et une portion périphérique de la deuxième chaine de cellules.

Un tel agencement permet d'obtenir une densité surfacique améliorée. Une continuité électrique entre cellules adjacentes est par ailleurs réalisée tout en évitant les courts-circuits.

Un tel agencement permet à nombre de cellules et taille de cellules égal par rapport à un module d'agencement conventionnel, d'avoir une encapsulation réduite.

Selon un mode de réalisation, la présente demande concerne un dispositif photovoltaïque comprenant un assemblage de plusieurs chaines de cellules, chacune des chaines étant formée d'une pluralité de cellules alignées dans une première direction y, les chaines étant alignées dans une deuxième direction x réalisant un angle non-nul avec la première direction et typiquement orthogonale ou sensiblement orthogonale à la première direction, l'assemblage de cellules comportant au moins une première chaine chevauchée latéralement par une deuxième chaine de la pluralité de chaines, de sorte qu'une portion périphérique de la deuxième chaine recouvre une portion périphérique de la première chaine, la première chaine et la deuxième chaine étant isolées électriquement par l'intermédiaire d'une région isolante intercalée entre les portions périphériques respectives de la première chaine et de la deuxième chaine.

« Par sensiblement parallèle », on entend ici qui réalise un angle inférieur à 5° et par « sensiblement orthogonal » on entend ici qui réalise un angle supérieur à 85°.

Avantageusement, la deuxième chaine de cellules est juxtaposée et chevauche latéralement ou est chevauchée latéralement par une troisième chaine de cellules.

La première chaine de cellules peut être revêtue d'une ou plusieurs première(s) piste(s) conductrice(s) qui s'étende(nt) parallèlement ou sensiblement parallèlement à la première direction y, la deuxième chaine de cellules étant revêtue d'une ou plusieurs deuxième(s) piste(s) conductrices qui s'étende(nt) parallèlement ou sensiblement parallèlement à la première direction y, la ou les première(s) pistes conductrices étant connectée(s) à la ou les deuxième(s) piste(s) conductrices par l'intermédiaire d'une zone conductrice d'interconnexion agencée d'un premier côté de l'assemblage à une première extrémité de la première chaine et à une première extrémité de la deuxième chaine.

Selon un mode de réalisation particulier, la deuxième chaine de cellules est juxtaposée et chevauche latéralement ou est chevauchée latéralement par une troisième chaine de cellules, la troisième chaine de cellules étant revêtue d'une ou plusieurs troisième(s) piste(s) conductrices qui s'étende(nt) en particulier parallèlement ou sensiblement parallèlement à la première direction, la troisième chaine de cellules étant juxtaposée et chevauchant latéralement ou étant chevauchée latéralement par une quatrième chaine de cellules, la quatrième chaine de cellules étant revêtue d'une ou plusieurs quatrième(s) piste(s) conductrices qui s'étende(nt) en particulier parallèlement ou sensiblement parallèlement à la première direction, la première chaine, la deuxième chaine, la troisième chaine, la quatrième chaine ayant une première extrémité située du premier côté de l'assemblage et une deuxième extrémité située d'un deuxième côté de l'assemblage opposé au premier côté de l'assemblage, les troisième(s) pistes conductrice(s) étant connectée(s) aux quatrième(s) piste(s) conductrices par l'intermédiaire d'une autre zone conductrice d'interconnexion agencée du deuxième côté de l'assemblage.

Avantageusement, la première extrémité et la deuxième extrémité de la première chaine sont décalées par rapport, respectivement, à la première extrémité et la deuxième extrémité de la deuxième chaine.

Selon un mode de réalisation avantageux, les cellules sont de type pseudo-carré, avec des bords en biseau, les cellules de la première chaine se chevauchant de sorte qu'un bord longitudinal d'une première cellule est agencé en regard des bords en biseau d'une deuxième cellule voisine de la première cellule.

Avantageusement, la région isolante est faite ou comprend un matériau ayant des propriétés adhésives.

Selon une possibilité de mise en œuvre, la région isolante peut être formée en un matériau transparent aux photons à une longueur d'onde comprise entre 200 nm et 1200 nm, en particulier entre 400 et 800 nm.

Selon un mode de réalisation, la région isolante peut être formée en un matériau thermoplastique ou thermodurcissable.

Selon un autre mode de réalisation, la région isolante peut être formée en un matériau inorganique.

Avantageusement, la région isolante peut être formée en un matériau ayant une tenue diélectrique supérieure à la valeur maximale de tension (Voc) présente entre deux chaines juxtaposées de cellules. La région isolante peut être en particulier formée en un matériau ayant une tenue diélectrique comprise entre 15 et 30 V.

Selon un autre aspect, la présente invention concerne un procédé de fabrication d'un dispositif photovoltaïque tel que défini précédemment.

Selon un mode de réalisation, le procédé comprend les étapes suivantes :
- assemblage d'un ensemble de cellules solaires de sorte à former au moins la première chaine de cellules et de passivation de portions périphériques opposées des cellules de l'ensemble de cellules et situées le long de bords latéraux des cellules, pour former la région isolante, puis,
- assemblage de la première chaine de cellules et de la deuxième chaine de cellules en réalisant le chevauchement latéral de la deuxième chaine sur la première chaine de cellules, la deuxième chaine de cellules étant disposée en contact avec la région isolante.

La passivation des portions périphériques peut être réalisée après une étape d'assemblage de cellules pour former la première chaine de cellules.

Avantageusement, le procédé peut comprendre la formation de pistes conductrices sur la première chaine et d'au moins une zone conductrice d'interconnexion avec des pistes conductrices d'une deuxième chaine de cellules adjacente à la première chaine, la zone conductrice d'interconnexion étant réalisée après la passivation.

### BRÈVE DESCRIPTION DES DESSINS

La présente invention sera mieux comprise sur la base de la description qui va suivre et des dessins en annexe sur lesquels :
La figure 1 illustre une chaine de cellules solaires agencées selon une configuration de type tuilage ou pavage (« paving »).
La figure 2 illustre un agencement suivant l'invention de chaines de cellules solaires parallèles avec un chevauchement latéral entre chaines de cellules solaires adjacentes.
La figure 3 illustre une variante de chevauchement latéral entre chaines de cellules solaires adjacentes.
La figure 4 illustre une région isolante intermédiaire entre chaines de cellules solaires adjacentes qui se chevauchent latéralement.
La figure 5 illustre un premier type d'agencement de chaines de cellules solaire se chevauchant latéralement.
La figure 6 illustre un autre type d'agencement de chaines de cellules solaire se chevauchant latéralement.
Les figures 7A, 7B et 7C illustrent un premier exemple de réalisation de la passivation de bords latéraux des chaines de cellules se chevauchant latéralement.
Les figures 8A, 8B et 8C illustrent un exemple de réalisation de la passivation de bords latéraux des chaines de cellules dans lequel la passivation est réalisée après l'assemblage des cellules en chaines de cellules.
Les figures 9A, 9B et 9C illustrent un exemple de réalisation de la passivation de bords latéraux des chaines de cellules dans lequel la passivation est réalisée avant assemblage des cellules en chaines de cellules.
La figure 10 illustre un exemple d'agencement particulier de chaines de cellules adjacentes avec des extrémités de chaines adjacentes décalées les unes des autres;=.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

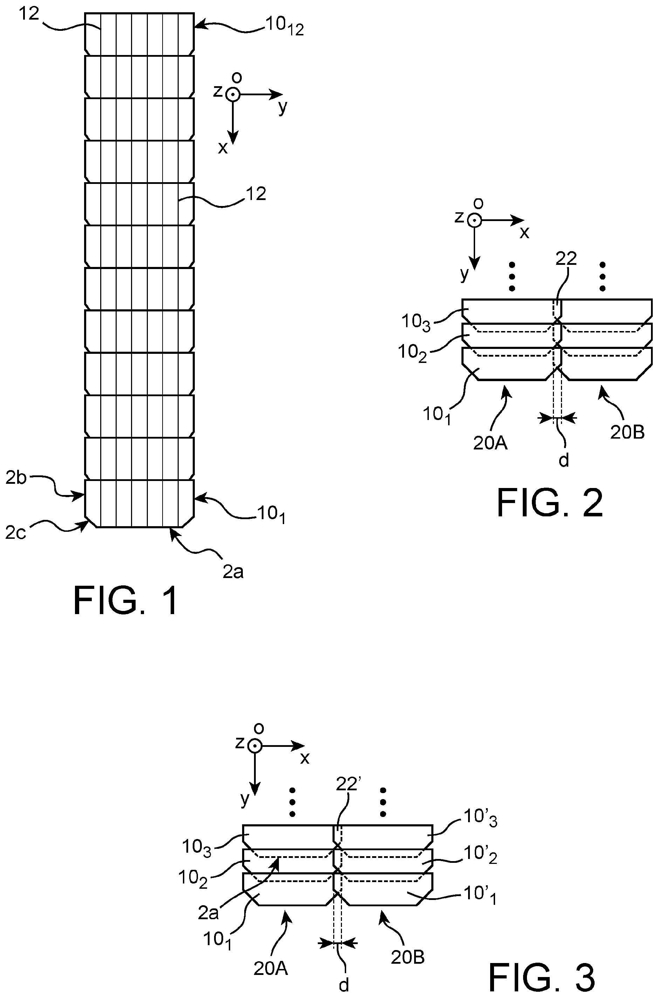

Un exemple d'agencement d'une chaine 20A (« string » selon la terminologie anglo-saxonne ») de cellules solaires 10₁,...,10₁₂ susceptible d'être intégrée à un module photovoltaïque tel que mis en œuvre suivant l'invention est illustré sur la figure 1.

Les cellules 10₁,...,10₁₂ sont, dans cet exemple, de type pseudo-carré ou pseudo-rectangulaire, avec des bords 2c en biseau obliques par rapport à des bords dits « latéraux » 2b et « longitudinaux » 2a de la cellule.

Les bords latéraux 2b sont ceux qui s'étendent dans une première direction, typiquement parallèle ou sensiblement parallèle à celle d'un axe y (d'un repère orthogonal [O;°x;°y;°z] sur la figure 1) qui correspond ici à la direction dans laquelle la chaine 20A de cellules 10₁,...,10₁₂ s'étend.

Les bords longitudinaux 2a sont ici ceux qui s'étendent dans une deuxième direction dans laquelle les chaines du module sont réparties. La deuxième direction est typiquement sensiblement orthogonale ou orthogonale à la première direction, autrement dit parallèle ou sensiblement parallèle à celle d'un axe x du repère orthogonal [O;°x;°y;°z].

L'agencement des cellules au sein de la chaine 20A est ici tel que d'une extrémité à l'autre de la chaine de cellules 10₁,..., 10₁₂, chaque cellule chevauche ou est chevauchée par une cellule adjacente de la succession de cellules 10₁,...,10₁₂ formant la chaine. Ainsi, chaque cellule est dotée d'un bord longitudinal 2a, qui est recouvert par une portion de cellule voisine ou se trouve à l'extrémité d'une portion qui dépasse en regard de la cellule voisine.

Dans l'exemple illustré, chaque cellule 10₁,...,10₁₂ s'étend en particulier dans un plan distinct de celui dans lesquels s'étendent respectivement les autres cellules 10₁,...,10₁₂. Un agencement différent au sein de la chaine 20A peut toutefois être prévu. Ainsi, en variante, les cellules 10₁,...,10₁₂ peuvent avoir un agencement dans lequel les cellules successives sont disposées alternativement dans un premier plan ou dans un deuxième plan distinct du premier plan et parallèle à ce dernier.

Les cellules 10₁,...,10₁₂ sont ici connectées électriquement par le biais d'un ou plusieurs éléments conducteurs 12 qui s'étendent sur les cellules sous forme de rubans conducteurs ou de fils conducteurs, par exemple un matériau métallique à base d'argent, et d'une extrémité à l'autre de la chaine de cellules 10₁,...,10₁₂. Les cellules 10₁,...,10₁₂ peuvent ainsi avoir un agencement et une connexion selon une configuration en tuilage (« paving »).

Dans l'exemple de réalisation particulier illustré, les éléments conducteurs 12 s'étendent sur une face dite « supérieure » de la chaine de cellules formée ici par l'ensemble dévoilé des faces avant des cellules 10₁,...,10₁₂.

Les fils 12 peuvent faire l'objet d'un écrasement le long de l'assemblage en chaine de cellules 10₁,..., 10₁₂, afin de limiter les contraintes mécaniques mais également d'augmenter l'adhésion de ces derniers aux cellules 10₁,..., 10₁₂. Les éléments conducteurs 12 peuvent-être fixés par collage, ou soudure, ou en utilisant une pâte à braser. En variante, ces éléments conducteurs 12 peuvent être disposés sur, ou intégrés à, une couche de matériau polymère que l'on rapporte sur les cellules 10₁,...,10₁₂.

Pour former un module photovoltaïque, la chaine 20A de cellules 10₁,..., 10₁₂, de cellule qui vient d'être décrite est destinée à être assemblée à d'autres chaines de cellules, lesquelles sont typiquement connectées entre elles en série.

En variante de l'exemple de configuration illustré, les cellules 10₁,...,10₁₂ peuvent avoir une configuration en bardeau (« shingle ») avec une connexion entre cellules voisines de sorte qu'une zone conductrice d'interconnexion est située entre une face supérieure d'une première cellule et une face inférieure d'une deuxième cellule voisine de la première cellule.

L'assemblage entre chaines de cellules a ici pour particularité de prévoir un chevauchement latéral entre chaines voisines de cellules.

Ainsi, sur la figure 2, le chevauchement latéral entre chaines de cellules est tel qu'une portion 22 d'une première chaine 20A de cellules 10₁, 10₂, 10₃ est disposée sur une portion (non référencée sur cette figure) d'une deuxième chaine 20B voisine autrement dit adjacente à la première. Le chevauchement latéral peut être tel qu'un dépassement d compris par exemple entre 0.01 mm et 5 mm, en particulier entre 0.5 et 1 mm d'une chaine de cellule 20A sur la chaine voisine 20B peut être prévu.

Afin de ne pas perdre ou de limiter une perte de zone active, la valeur de ce dépassement d (appelé également « recouvrement ») peut être avantageusement proche de celle d'un détourage (non représenté) typiquement prévu en face arrière des cellules. Un tel détourage peut correspondre à une zone périphérique inactive à l'inverse de celle active et centrale généralement revêtue de matériau conducteur transparent tel que de l'ITO (Pour « indium tin oxide » ou oxyde d'indium-étain »).

Sur la figure 3, un chevauchement latéral est également prévu entre les chaines 20A, 20B de cellules, mais cette fois de sorte qu'une portion 22' de la deuxième chaine 20B de cellules 10'₁, 10'₂, 10'₃ recouvre une portion (non référencée sur cette figure) de la chaine 20A.

Plutôt qu'une simple juxtaposition avec des chaines de cellules espacées les unes des autres, un tel chevauchement latéral contribue à une densification du module photovoltaïque, comportant par exemple entre 2 et 20 chaines de cellules parallèles.

Pour permettre un tel chevauchement latéral d'une chaine de cellules sur une chaine voisine tout en évitant de mettre entre elles ces chaines de cellules adjacentes en court-circuit, on prévoit une région 31 intermédiaire en matériau isolant électriquement 32. Cette région 31 appelée région isolante 31 est ainsi disposée au moins dans la zone de chevauchement et sur une portion des faces des cellules de la chaine 20A qui est chevauchée et recouverte par les cellules de la chaine 20B voisine.

On prévoit de préférence le matériau de la région isolante 31 avec une transparence optique aux photons pour une longueur d'onde comprise entre 200 nm et 1200 nm.

La région isolante 31 peut être sous forme d'une couche ou d'une bande, par exemple en matériau thermoplastique, ou thermodurcissable, ou d'un film isolant. Le matériau isolant 32 peut être avantageusement un polymère, par exemple du polyéthylène téréphtalate (PET). Le matériau isolant 32 peut éventuellement revêtu d'un matériau adhésif ou avoir lui-même des propriétés adhésives. Une couche de PET avec adhésif acrylique comme par exemple une couche commercialisée sous le nom de tesa^{®} 4129 peut être par exemple employée. Une couche de matériau isolant 32, en particulier polymère, et ayant des propriétés adhésives sur une de ses faces ou sur ses deux faces peut être employée.

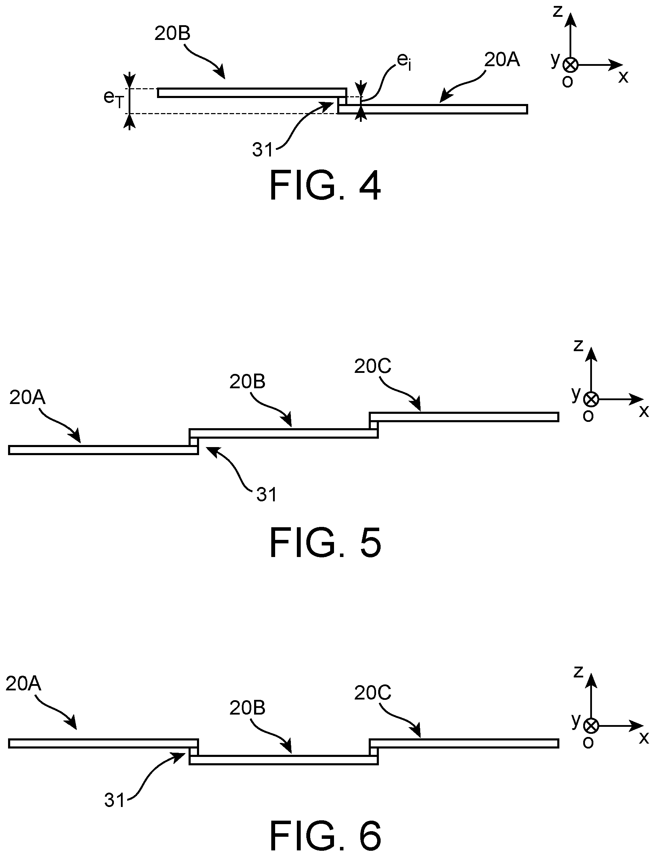

La région isolante 31 est prévue, en termes de composition et d'épaisseur, de manière à avoir une bonne tenue diélectrique et en particulier une tenue diélectrique supérieure à un rapport d'une différence de tension maximale en deux chaines adjacentes 20A, 20B de cellules et de l'épaisseur e_{T} du dispositif (dimension mesurée par parallèlement à l'axe z sur la figure 4).

Dans le cas particulier d'une région 31 en matériau isolant 32 par exemple polymère et de rigidité électrique de l'ordre de 15 kV/mm, un maximum de tension de l'ordre de 17 V entre deux chaines 20A, 20B adjacentes (correspondant par exemple à 12 cellules par chaine et une tension de 0,7V par cellule) une épaisseur eᵢ d'au moins de 2 µm du polymère isolant est prévue afin d'assurer la fonction. De manière avantageuse, la région 31 en matériau isolant 32 peut être prévue avec une tension minimale à tenir, comprise entre 15 V et 30 V.

De préférence également, le matériau de la région isolante 31 est choisi de sorte qu'il conserve ses propriétés de tenue diélectrique jusqu'à une température, par exemple de l'ordre de 200°C, à laquelle il est susceptible d'être soumis lors du procédé de fabrication du module.

La répartition de la région isolante 31 n'est pas limitée à celle illustrée sur la figure 4. Elle peut éventuellement s'étendre au-delà de la zone intercalaire entre cellules de chaines distinctes.

Hormis l'isolation électrique entre chaines de cellules adjacentes, la région isolante 31 peut avoir un rôle de tenue mécanique de l'assemblage entre chaines de cellules adjacentes. Ainsi, cette région isolante 31 peut participer au maintien solidaire des chaines de cellules voisines notamment au cours de la fabrication du module. En particulier lors d'une étape de lamination couramment utilisée et lors de laquelle l'assemblage est soumis à une pression, la région isolante 31 permet d'éviter un déplacement des chaines de cellules les unes par rapport aux autres.

Comme pour les cellules au sein d'une même chaine, les chaines de cellules peuvent être prévues entre elles avec un agencement tel que sur la figure 5 ou un agencement comme sur la figure 6.

Dans le premier type d'agencement, chaque chaine 20A ou 20B ou 20C se situe dans un plan distinct de ceux dans lesquels s'étendent respectivement les autres chaines 20A, 20B, 20C.

Dans le deuxième type d'agencement, les chaines 20A, 20B, 20C se situent alternativement dans un premier plan et dans un deuxième plan distinct du premier plan.

L'assemblage à chevauchement latéral des chaines de cellules peut s'intégrer dans un procédé de fabrication de module conventionnel tout en limitant le rajout d'étapes supplémentaires.

Une étape supplémentaire de passivation de portions latérales de chaine de cellules sur lesquelles une chaine voisine est destinée à reposer peut être prévue.

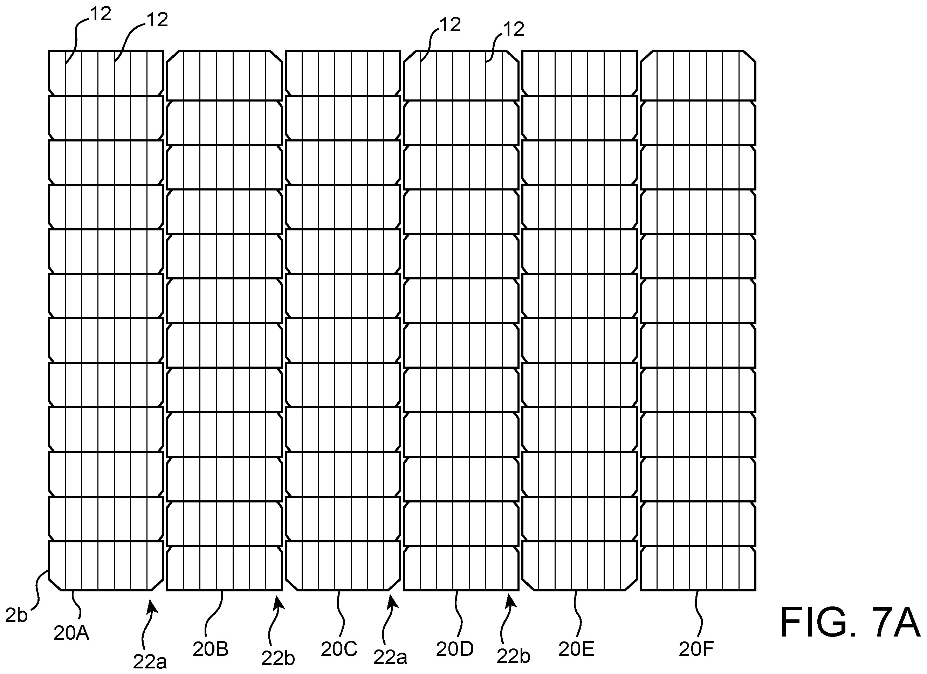

Ainsi, dans l'exemple de réalisation illustré sur les figures 7A-7B, on forme tout d'abord plusieurs chaines 20A, 20B, 20C, 20D, 20E, 20F, de cellules (figure 7A).

Les chaines de cellules sont alors chacune dotées d'éléments conducteurs de type ruban ou fils conducteurs 12 qui s'étendent dans la direction principale de la chaine (autrement dit la direction dans laquelle l'ensemble des cellules de cette chaine s'étend).

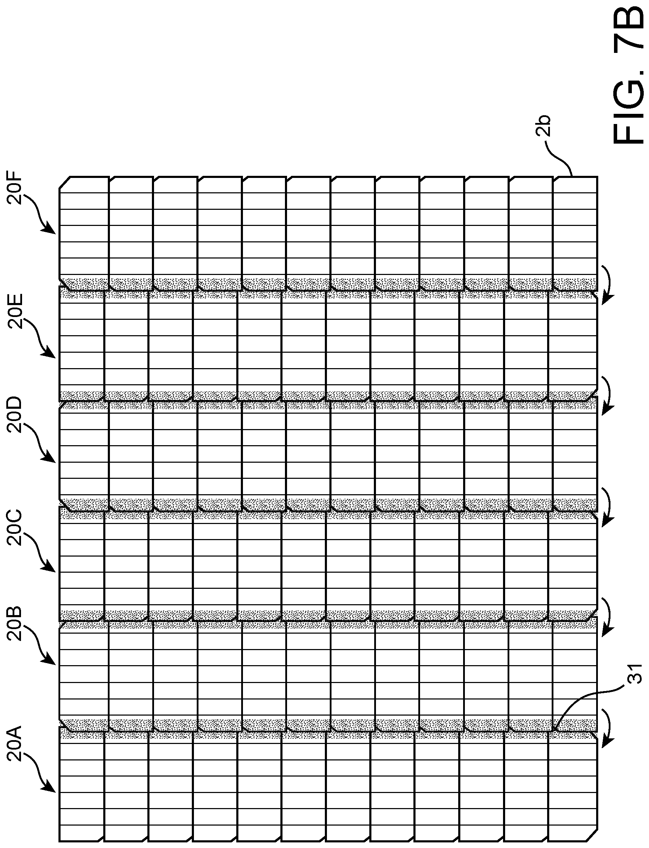

On revêt ensuite de matériau isolant 32 (figure 7B) des portions périphériques 22a, 22b des cellules situées le long de leurs bords latéraux 2b respectifs, pour former la ou les régions isolantes 31.

Un dépôt localisé de matériau isolant directement sur la chaine de cellules en particulier en utilisant une technique de dépôt en phase liquide ou une technique d'impression par jet d'encre, ou de pulvérisation liquide (« spray » selon la terminologie anglo-saxonne), ou de trempage, ou d'estampillage (« stamping » selon la terminologie anglo-saxonne) peut être effectué.

Cette étape de passivation peut être réalisée par le biais d'un équipement existant et/ou adapté pour réaliser d'autres étapes. Une machine de réalisation des chaines (« stringer » selon la terminologie anglo-saxonne) ou bien une machine de pose des chaines, ou bien un équipement dédié à la réalisation des chaines ainsi qu'à leur assemblage peut être modifié et adapté pour réaliser une telle étape.

Une technique particulière de dépôt du matériau isolant utilise une encre contenant un matériau polymère, de préférence thermodurcissable, et par exemple à base d'Epoxy, ou de silicone, ou de polyuréthane, ou d'acrylique, ou d'acrylate. Une cuisson ou réticulation du ou des polymères déposés par voie liquide peut être alors réalisée de manière conventionnelle par irradiation UV, ou bien par chauffage avec un profil thermique variable adapté, ou bien directement à l'air.

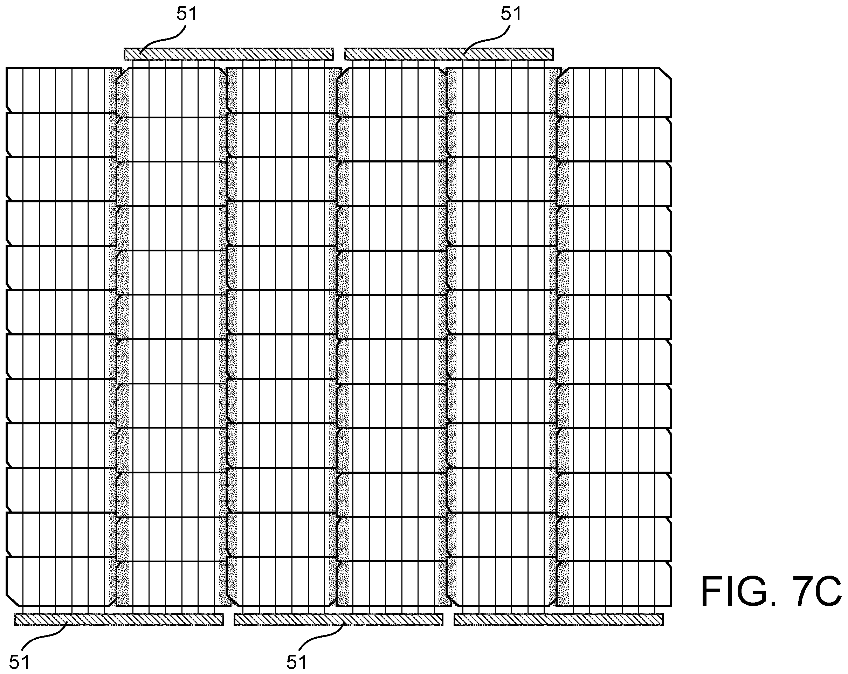

Ensuite (figure 7C), on forme aux extrémités des chaines de cellules 20A, 20B, 20C, 20D, 20E de part et d'autre de l'assemblage des zones de connexion, en particulier des zones 51 d'interconnexion entre cellules adjacentes.

La mise en œuvre du chevauchement latéral permet de diminuer la quantité de matériaux utilisés en particulier pour réaliser l'encapsulation. Le procédé est intégrable dans une ligne de production de modules photovoltaïques sans introduire de surcoût.

La passivation des bords de chaines peut être en variante réalisée avant la formation des lignes conductrices 12 parallèles formées le long de chaque chaine.

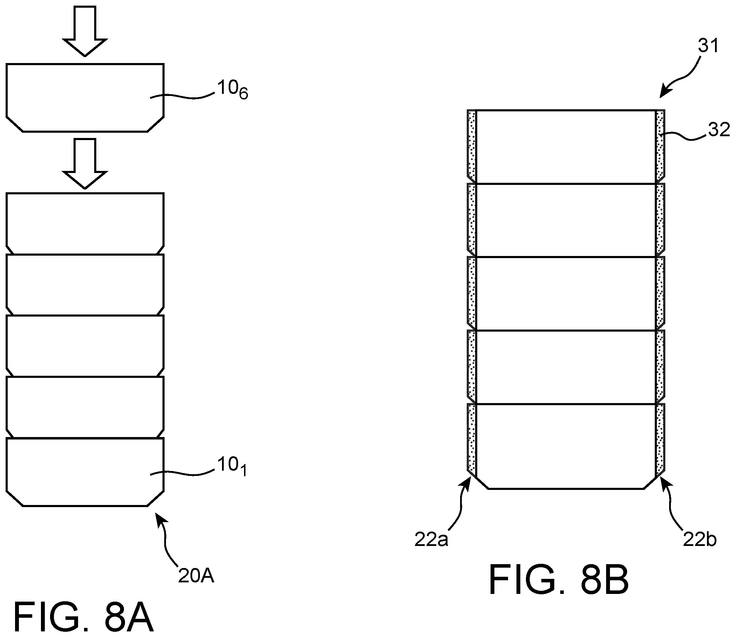

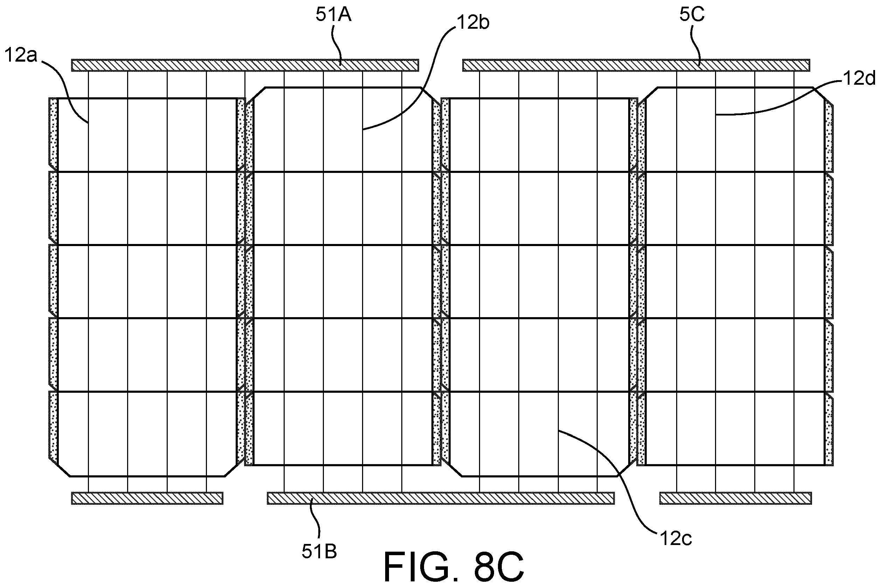

Ainsi, dans l'exemple de procédé de fabrication illustré sur les figures 8A-8C, on réalise tout d'abord (figure 8A), un assemblage de cellules en une chaine 20A (« string ») de cellules 10₁,...,10₆.

Puis (figure 8B), on forme une région isolante 31 sur les portions périphériques 22a, 22b au niveau des bords latéraux 2a des cellules de cette chaine 20A.

Puis, on effectue l'assemblage de cette chaine 20A de cellules avec une chaine adjacente ou un ensemble de chaines déjà assemblées, en réalisant un chevauchement latéral tel que décrit précédemment.

Ainsi, une première chaine 20A de cellules est revêtue de première(s) pistes conductrices 12a tandis que la deuxième chaine 20B de cellules est revêtue de deuxièmes pistes conductrices 12b, les premières pistes conductrices 12a étant connectées aux deuxièmes pistes conductrices 12b par l'intermédiaire d'une zone conductrice électriquement 51A d'interconnexion agencée d'un premier côté de l'assemblage à une première extrémité de ladite première chaine 20A et de la deuxième chaine 20B. La deuxième chaine 20B de cellules qui est chevauchée latéralement ou chevauche latéralement une troisième chaine 20C de cellules est revêtue de troisièmes pistes conductrices 12c. La troisième chaine de cellules est chevauchée latéralement ou chevauche une quatrième chaine 20D de cellules, elle-même revêtue de quatrièmes pistes conductrices 12d. Les troisièmes pistes conductrices 12c étant connectées aux quatrièmes pistes conductrices 12d par l'intermédiaire d'une autre zone conductrice électriquement 51B d'interconnexion agencée d'un deuxième côté de l'assemblage opposé au premier côté de l'assemblage où se situe la zone d'interconnexion 51A des première et deuxièmes pistes conductrices 12a, 12b.

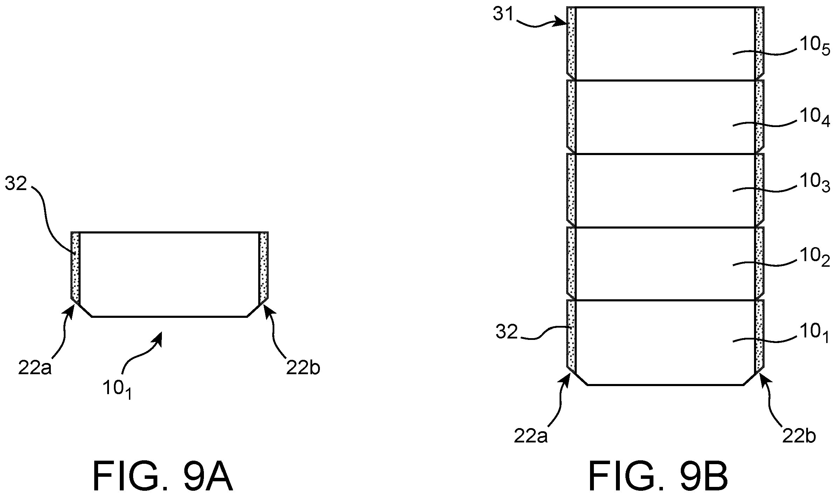

Selon une autre variante de réalisation illustrée sur les figures 9A-9C, on réalise tout d'abord (figure 9A) une zone de passivation en matériau isolant 32 sur des portions périphériques 22a, 22b d'au moins une face, en particulier la face avant, d'une cellule solaire 10₁.

On assemble ensuite (figure 9B) cette cellule 10₁ avec d'autres cellules afin de constituer une chaine 20A de cellules, chacune des cellules 10₁, 10₂, 10₃, 10₄, 10₅ de cette chaine étant revêtue de préférence de zones de passivation en matériau isolant 32 sur des portions 22a, 22b périphériques.

La chaine de cellules ainsi formée est dotée de portions latérales avec une région isolante 31 ici formée par l'ensemble des zones de passivation individuelles des cellules de la chaine.

Puis, on réalise l'assemblage entre chaines de cellules en effectuant un chevauchement latéral tel que décrit précédemment.

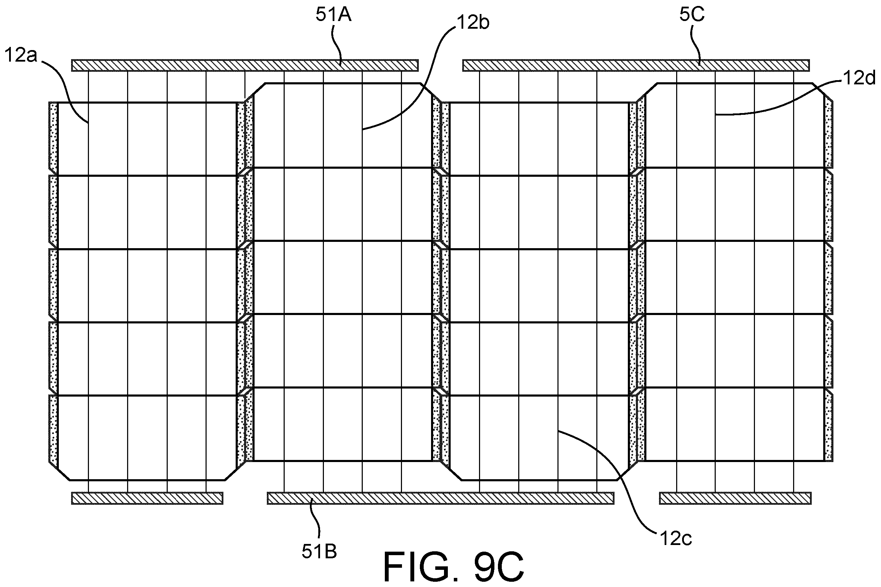

Ensuite (figure 9C), on connectant entre elles les cellules au sein de chaque chaine et des zones 51A, 51B d'interconnexion en chaînes voisines.

Dans l'un ou l'autre des exemples de réalisation décrits précédemment, l'ensemble des chaines de cellules est réparti de telle sorte que les chaines de cellules sont typiquement de même longueur et disposées parallèlement les unes aux autres, avec par conséquent leurs extrémités respectives alignées. C'est le cas par exemple sur la figure 7C.

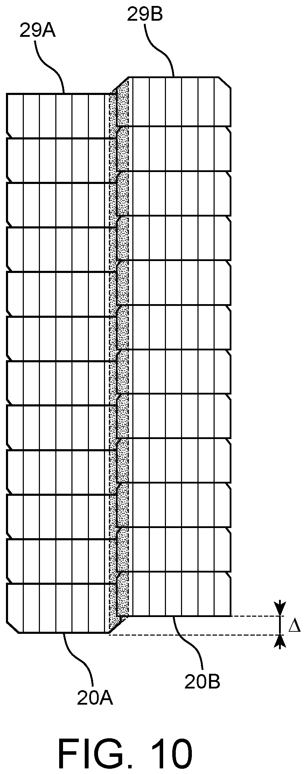

En variante, on peut prévoir comme sur la figure 10, un décalage Δ entre les extrémités 29A, 29B respectives de chaines adjacentes 20A, 20B de cellules. Un tel décalage peut être envisagé en particulier lorsque l'on prévoit un chevauchement des cellules entre elles au sein d'une même chaine. Dans ce cas, on évite la formation de points de croisement en quatre cellules distinctes et d'avoir, en ces points singuliers, quatre épaisseurs de cellules. Selon un exemple de réalisation particulier d'une telle variante, une répartition en quinconce des extrémités des chaines de cellules peut être prévue.

Un décalage typiquement entre 1 mm et une longueur de l'ordre de la moitié de la taille de la cellule peut être prévu.

L'agencement particulier décrit plus haut de chaines (« string ») qui se chevauchent latéralement a été illustré précédemment en combinaison avec un agencement particulier des cellules au sein d'une chaine de cellule dans laquelle les cellules se chevauchent entre elles deux à deux, par exemple selon un agencement de type pavage (« paving ») ou en bardeau (« shingle »).

Toutefois, les chaines adjacentes avec débordement latéral peuvent être, en variante, des chaines dans lesquelles un agencement conventionnel de cellules est prévu. Ainsi, le chevauchement latéral des chaines de cellules peut être également mis en œuvre avec une succession de cellules disposées l'une après l'autre sans recouvrement des cellules entre elles au sein d'une même chaine.

Le chevauchement latéral des chaines de cellules décrit plus haut s'applique à différents types de cellules, par exemple également à des cellules de type à contact arrière interdigités (IBC pour « Interdigitated Back Contact »).

Le chevauchement latéral des chaines s'applique également à différentes technologies de fabrication des chaines de cellules, par exemple également à celle mettant en œuvre une interconnexion particulière de type SWCT^{™}.

Un module solaire avec chevauchement latéral des chaines de cellules tel que décrit précédemment trouve des applications diverses. Par exemple, il peut être intégré à une ferme solaire ou à un toit terrasse, à un véhicule solaire, voire trouver des applications dans le domaine spatial.

## Revendications

1. Dispositif photovoltaïque comprenant un assemblage de plusieurs chaines (20A, 20B, 20C, 20D, 20E, 20F) de cellules photovoltaïques (10₁,...,10₁₂), chacune desdites chaines étant formée d'une pluralité de cellules photovoltaïques alignées dans une première direction (y), lesdites chaines étant alignées dans une deuxième direction (x) réalisant un angle non-nul avec la première direction et typiquement orthogonale ou sensiblement orthogonale à la première direction, ledit assemblage comportant au moins une première chaine (20A) chevauchée latéralement par une deuxième chaine (20B) de ladite pluralité de chaines, de sorte qu'une portion périphérique (22') de ladite deuxième chaine recouvre une portion périphérique de ladite première chaine, ladite première chaine (20A) et ladite deuxième chaine (20B) étant isolées électriquement par l'intermédiaire d'une région isolante (31) intercalée entre lesdites portions périphériques respectives de la première chaine et de la deuxième chaine.

2. Dispositif photovoltaïque selon la revendication 1, dans lequel ladite deuxième chaine (20B) de cellules est juxtaposée et chevauche latéralement ou est chevauchée latéralement par une troisième chaine (20C) de cellules.

3. Dispositif photovoltaïque selon l'une des revendications 1 ou 2, dans lequel dans ladite première chaine (20A) de cellules est revêtue d'une ou plusieurs première(s) piste(s) conductrice(s) (12a) qui s'étende(nt) parallèlement ou sensiblement parallèlement à la première direction (y), ladite deuxième chaine de cellules étant revêtue d'une ou plusieurs deuxième(s) piste(s) conductrices (12b) qui s'étende(nt) parallèlement ou sensiblement parallèlement à la première direction (y), la ou les première(s) pistes conductrices (12a) étant connectée(s) à la ou les deuxième(s) piste(s) conductrices (12b par l'intermédiaire d'une zone conductrice électriquement (51) d'interconnexion agencée d'un premier côté de l'assemblage à une première extrémité de ladite première chaine (20A) et à une première extrémité de ladite deuxième chaine (20B).

4. Dispositif photovoltaïque selon la revendication 3, dans lequel la deuxième chaine (20B) de cellules est juxtaposée et chevauche latéralement ou est chevauchée latéralement par une troisième chaine (20C) de cellules, la troisième chaine de cellules étant revêtue d'une ou plusieurs troisième(s) piste(s) conductrices (12) qui s'étende(nt) en particulier parallèlement ou sensiblement parallèlement à la première direction, la troisième chaine de cellules étant juxtaposée et chevauchant latéralement ou étant chevauchée latéralement par une quatrième chaine (20D) de cellules, ladite quatrième chaine de cellules étant revêtue d'une ou plusieurs quatrième(s) piste(s) conductrices (12) qui s'étende(nt) en particulier parallèlement ou sensiblement parallèlement à la première direction, la première chaine (20A), la deuxième chaine (20B), la troisième chaine (20C), la quatrième chaine (20D) ayant une première extrémité située du premier côté de l'assemblage et une deuxième extrémité située d'un deuxième côté de l'assemblage opposé audit premier côté de l'assemblage, les troisième(s) pistes conductrice(s) étant connectée(s) électriquement auxdites quatrième(s) piste(s) conductrices par l'intermédiaire d'une autre zone conductrice électriquement (51) d'interconnexion agencée dudit deuxième côté de l'assemblage.

5. Dispositif photovoltaïque selon l'une des revendications 3 ou 4, dans lequel la première extrémité et la deuxième extrémité de la première chaine (20A) sont décalées par rapport, respectivement, à la première extrémité et la deuxième extrémité de la deuxième chaine (20B).

6. Dispositif photovoltaïque selon l'une des revendications 1 à 5, dans lequel lesdites cellules sont de type pseudo-carré, avec des bords (2c) en biseau, les cellules de la première chaine (20A) se chevauchant de sorte qu'un bord longitudinal (2a) d'une première cellule (10₁) est agencé en regard desdits bords en biseau d'une deuxième cellule (10₂) voisine de ladite première cellule (10₁).

7. Dispositif photovoltaïque selon l'une des revendications 1 à 6, dans lequel la région isolante (31) est faite ou comprend un matériau (32) ayant des propriétés adhésives.

8. Dispositif photovoltaïque selon l'une des revendications 1 à 6, la région isolante (31) étant formée en un matériau (32) transparent aux photons à une longueur d'onde comprise entre 200 nm et 1200 nm, avantageusement entre 400 et 800 nm.

9. Dispositif photovoltaïque selon l'une des revendications 1 à 8, la région isolante (31) étant formée en un matériau thermoplastique ou thermodurcissable.

10. Dispositif photovoltaïque selon l'une des revendications 1 à 9, la région isolante étant formée en un matériau (32) ayant une tenue diélectrique comprise entre 15 et 30 V.

11. Procédé de fabrication d'un dispositif photovoltaïque selon l'une des revendications 1 à 10, comprenant les étapes suivantes :
- assemblage d'un ensemble de cellules photovoltaïques (10₁, 10₂, 10₃, 10₄, 10₅, 10₆) de sorte à former au moins la première chaine (20A) de cellules et de passivation de portions périphériques opposées (22a, 22b) des cellules dudit ensemble de cellules et situées le long de bords latéraux desdites cellules, pour former ladite région isolante (31), puis,
- assemblage de la première chaine (20A) de cellules et de la deuxième chaine (20B) de cellules en réalisant le chevauchement latéral de la deuxième chaine sur la première chaine de cellules, la deuxième chaine de cellules étant disposée en contact avec ladite région isolante (31).

12. Procédé selon la revendication 11, dans lequel la passivation des portions périphériques (22a, 22b) est réalisée après une étape d'assemblage de cellules pour former ladite première chaine de cellules.

13. Procédé selon l'une des revendications 11 ou 12, comprenant en outre la formation de pistes conductrices sur ladite première chaine (20A) et d'au moins une zone conductrice (51) d'interconnexion avec des pistes conductrices d'une deuxième chaine de cellules adjacente à la première chaine (20A), ladite zone conductrice (51) d'interconnexion étant réalisée après ladite passivation.

## Patentansprüche

1. Photovoltaikvorrichtung mit einer Anordnung aus mehreren Ketten (20A, 20B, 20C, 20D, 20E, 20F) von Photovoltaikzellen (10₁,...,10₁₂), wobei jede der Ketten aus einer Vielzahl von Photovoltaikzellen gebildet ist, die in einer ersten Richtung (y) ausgerichtet sind, wobei die Ketten in einer zweiten Richtung (x) ausgerichtet sind, die einen Winkel ungleich Null mit der ersten Richtung bildet und typischerweise orthogonal oder im Wesentlichen orthogonal zu der ersten Richtung ist, wobei die Anordnung mindestens eine erste Kette (20A) umfasst, die seitlich von einer zweiten Kette (20B) der Vielzahl von Ketten überlappt wird, so dass ein Umfangsabschnitt (22') der zweiten Kette einen Umfangsabschnitt der ersten Kette überlappt, wobei die erste Kette (20A) und die zweite Kette (20B) über einen Isolierbereich (31), der zwischen den jeweiligen Umfangsabschnitten der ersten Kette und der zweiten Kette eingefügt ist, elektrisch isoliert sind.

2. Photovoltaikvorrichtung nach Anspruch 1, wobei die zweite Kette (20B) von Zellen nebeneinander angeordnet ist und seitlich überlappt oder seitlich von einer dritten Kette (20C) von Zellen überlappt wird.

3. Photovoltaikvorrichtung nach einem der Ansprüche 1 oder 2, wobei in der ersten Kette (20A) von Zellen eine oder mehrere erste Leiterbahnen (12a) beschichtet ist, die sich parallel oder im Wesentlichen parallel zur ersten Richtung (y) erstreckt/erstrecken, wobei die zweite Kette von Zellen mit einer oder mehreren zweiten Leiterbahnen (12b) beschichtet ist, die sich parallel oder im Wesentlichen parallel zu der ersten Richtung (y) erstreckt/erstrecken, wobei die erste(n) Leiterbahn(en) (12a) mit der/den zweiten Leiterbahn(en) (12b) über einen elektrisch leitenden Verbindungsbereich (51) verbunden ist/sind, der auf einer ersten Seite der Baugruppe an einem ersten Ende der ersten Kette (20A) und an einem ersten Ende der zweiten Kette (20B) angeordnet ist.

4. Photovoltaikvorrichtung nach Anspruch 3, wobei die zweite Kette (20B) von Zellen nebeneinander angeordnet ist und seitlich überlappt oder seitlich von einer dritten Kette (20C) von Zellen überlappt wird, die dritte Kette von Zellen mit einer oder mehreren dritten Leiterbahnen (12) beschichtet ist, die sich insbesondere parallel oder im Wesentlichen parallel zu der ersten Richtung erstreckt/erstrecken, wobei die dritte Kette von Zellen nebeneinander angeordnet ist und seitlich überlappt oder seitlich von einer vierten Kette (20D) von Zellen überlappt wird, wobei die vierte Kette von Zellen mit einer oder mehreren vierten Leiterbahnen (12) beschichtet ist, die sich insbesondere parallel oder im Wesentlichen parallel zu der ersten Richtung erstreckt/erstrecken, wobei die erste Kette (20A), die zweite Kette (20B), die dritte Kette (20C), die vierte Kette (20D) ein erstes Ende aufweist, das auf der ersten Seite der Verbindung angeordnet ist, und ein zweites Ende, das auf einer zweiten Seite der Verbindung angeordnet ist, die der ersten Seite der Verbindung gegenüberliegt, wobei die dritte(n) Leiterbahn(en) mit der/den vierten Leiterbahn(en) über einen weiteren elektrisch leitenden Verbindungsbereich (51), der auf der zweiten Seite der Verbindung angeordnet ist, elektrisch verbunden ist/sind.

5. Photovoltaikvorrichtung nach einem der Ansprüche 3 oder 4, wobei das erste Ende und das zweite Ende der ersten Kette (20A) in Bezug auf das erste Ende beziehungsweise das zweite Ende der zweiten Kette (20B) versetzt sind.

6. Photovoltaikvorrichtung nach einem der Ansprüche 1 bis 5, wobei die Zellen pseudoquadratisch sind, mit abgeschrägten Rändern (2c), wobei sich die Zellen der ersten Kette (20A) überlappen, so dass eine Längskante (2a) einer ersten Zelle (10₁) gegenüber den abgeschrägten Rändern einer zweiten Zelle (10₂) angeordnet ist, die der ersten Zelle (10₁) benachbart ist.

7. Photovoltaikvorrichtung nach einem der Ansprüche 1 bis 6, wobei der Isolierbereich (31) aus einem Material (32) mit Klebeeigenschaften besteht oder dieses umfasst.

8. Photovoltaikvorrichtung nach einem der Ansprüche 1 bis 6, wobei der Isolierbereich (31) aus einem photonentransparenten Material (32) bei einer Wellenlänge zwischen 200 nm und 1200 nm, vorteilhafterweise zwischen 400 und 800 nm, gebildet ist.

9. Photovoltaikvorrichtung nach einem der Ansprüche 1 bis 8, wobei der Isolierbereich (31) aus einem thermoplastischen oder duroplastischen Material gebildet ist.

10. Photovoltaikvorrichtung nach einem der Ansprüche 1 bis 9, wobei der Isolierbereich aus einem Material (32) mit einer Dielektrizitätsfestigkeit zwischen 15 und 30 V gebildet ist.

11. Verfahren zur Herstellung einer Photovoltaikvorrichtung nach einem der Ansprüche 1 bis 10, umfassend folgende Schritte:
- Zusammenfügen eines Satzes von Photovoltaikzellen (10₁, 10₂, 10₃, 10₄, 10₅, 10₆), um mindestens die erste Kette (20A) von Zellen zu bilden, und Passivierung von gegenüberliegenden Umfangsabschnitten (22a, 22b) der Zellen des Satzes von Zellen und entlang von Seitenkanten der Zellen, um den isolierenden Bereich (31) zu bilden, und anschließend,
- Zusammenfügen der ersten Kette (20A) von Zellen und der zweiten Kette (20B) von Zellen durch seitliches Überlappen der zweiten Kette über die erste Kette von Zellen, wobei die zweite Kette von Zellen in Kontakt mit dem Isolierbereich (31) angeordnet ist.

12. Verfahren nach Anspruch 11, wobei die Passivierung der Umfangsabschnitte (22a, 22b) nach einem Schritt des Zusammenfügens von Zellen zur Bildung der ersten Kette von Zellen durchgeführt wird.

13. Verfahren nach einem der Ansprüche 11 oder 12, ferner umfassend die Bildung von Leitbahnen auf der ersten Kette (20A) und mindestens einem leitenden Verbindungsbereich (51) mit Leitbahnen einer zweiten Kette von Zellen, die an die erste Kette (20A) angrenzen, wobei der leitende Verbindungsbereich (51) nach der Passivierung hergestellt wird.

## Claims

1. A photovoltaic device comprising an assembly of several strings (20A, 20B, 20C, 20D, 20E, 20F) of photovoltaic cells (10₁,...,10₁₂), each of said strings being formed by a plurality of photovoltaic cells aligned in a first direction (y), said strings being aligned in a second direction (x) forming a non-zero angle with the first direction and typically orthogonal or substantially orthogonal to the first direction, said assembly including at least one first string (20A) laterally overlapped by a second string (20B) of said plurality of strings, so that a peripheral portion (22') of said second string covers a peripheral portion of said first string, said first string (20A) and said second string (20B) being electrically insulated via an insulating region (31) interposed between said respective peripheral portions of the first string and of the second string.

2. The photovoltaic device according to claim 1, wherein said second string (20B) of cells is juxtaposed and laterally overlaps or is laterally overlapped by a third string (20C) of cells.

3. The photovoltaic device according to one of claims 1 or 2, wherein said first string (20A) of cells is coated with one or more first conductive track(s) (12a) which extend(s) parallel or substantially parallel to the first direction (y), said second string of cells being coated with one or more second conductive track(s) (12b) which extend(s) parallel or substantially parallel to the first direction (y), the first conductive track(s) (12a) being connected to the second conductive track(s) (12b) via an interconnection electrically-conductive area (51) arranged on a first side of the assembly at a first end of said first string (20A) and at a first end of said second string (20B).

4. The photovoltaic device according to claim 3, wherein the second string (20B) of cells is juxtaposed and laterally overlaps or is laterally overlapped by a third string (20C) of cells, the third string of cells being coated with one or more third conductive track(s) (12) which extend(s) in particular parallel or substantially parallel to the first direction, the third string of cells being juxtaposed and laterally overlapping or being laterally overlapped by a fourth string (20D) of cells, said fourth string of cells being coated with one or more fourth conductive track(s) (12) which extend(s) in particular parallel or substantially parallel to the first direction, the first string (20A), the second string (20B), the third string (20C), the fourth string (20D) having a first end located on the first side of the assembly and a second end located on a second side of the assembly opposite to said first side of the assembly, the third conductive track(s) being electrically connected to said fourth conductive track(s) via another interconnection electrically-conductive area (51) arranged on said second side of the assembly.

5. The photovoltaic device according to one of claims 3 or 4, wherein the first end and the second end of the first string (20A) are offset respectively with respect to the first end and the second end of the second string (20B).

6. The photovoltaic device according to one of claims 1 to 5, wherein said cells are of the pseudo-square type, with beveled edges (2c), the cells of the first string (20A) overlapping so that a longitudinal edge (2a) of a first cell (10₁) is arranged opposite said beveled edges of a second cell (10₂) next to said first cell (10₁).

7. The photovoltaic device according to one of claims 1 to 6, wherein the insulating region (31) is made of or comprises a material (32) having adhesive properties.

8. The photovoltaic device according to one of claims 1 to 6, the insulating region (31) being formed of a material (32) transparent to photons at a wavelength comprised between 200 nm and 1,200 nm, advantageously between 400 and 800 nm.

9. The photovoltaic device according to one of claims 1 to 8, the insulating region (31) being formed of a thermoplastic or thermosetting material.

10. The photovoltaic device according to one of claims 1 to 9, the insulating region being formed of a material (32) having a dielectric strength comprised between 15 and 30 V.

11. A method for manufacturing a photovoltaic device according to one of claims 1 to 10, comprising the following steps:
- assembling a set of photovoltaic cells (10₁, 10₂, 10₃, 10₄, 10₅, 10₆) so as to form at least the first string (20A) of cells and of passivating opposite peripheral portions (22a, 22b) of the cells of said set of cells and located along lateral edges of said cells, to form said insulating region (31), then
- assembling the first string (20A) of cells and the second string (20B) of cells by carrying out the lateral overlap of the second string over the first string of cells, the second string of cells being arranged in contact with said insulating region (31).

12. The method according to claim 11, wherein the passivation of the peripheral portions (22a, 22b) is carried out after a step of assembling cells to form said first string of cells.

13. The method according to one of claims 11 or 12, further comprising forming conductive tracks over said first string (20A) and at least one interconnection conductive area (51) with conductive tracks of a second string of cells adjacent to the first string (20A), said interconnection conductive area (51) being made after said passivation.
